# EUROPEAN PATENT SPECIFICATION

(11) **EP 0 386 779 B1**
(45) Date of publication and mention of the grant of the patent: **19.06.1996**
(21) Application number: 90104524.5
(22) Date of filing: 09.03.1990
(51) Int. Cl.: H01L 29/78, H01L 27/088

(54) **MOS field-effect transistor having a high breakdown voltage**
MOS-Feldeffekttransistor mit hoher Durchbruchsspannung
Transistor à effet de champ de type MOS ayant une tension de claquage élevée

(30) Priority: 10.03.1989 JP 56103/89
(43) Date of publication of application: 12.09.1990
(73) Proprietor: KABUSHIKI KAISHA TOSHIBA, Kawasaki-shi, Kanagawa-ken 210 (JP)
(72) Inventor: Shirai, Koji, c/o Intellectual Property Div., Minato-ku, Tokyo 105 (JP); Kawamura, Ken, c/o Intellectual Property Div., Minato-ku, Tokyo 105 (JP)
(74) Representative: Lehn, Werner, Dipl.-Ing.

(56) References cited:
- EP-A- 0 080 740
- EP-A- 0 248 292
- US-A- 3 787 962
- PATENT ABSTRACTS OF JAPAN vol. 7, no. 214 (E-199)(1359) 21 September 1983 ; & JP-A-58 106 871

## Description

The present invention relates to a semiconductor device comprising:
a semiconductor substrate of a first conductivity type;
a first well of a second conductivity type formed on said semiconductor substrate of the first conductivity type;
a first impurity diffusion layer of the first conductivity type formed on said well without contacting said semiconductor substrate;
a second impurity diffusion layer of the second conductivity type which has an impurity concentration which is higher than that of said well;
a third impurity diffusion layer of the first conductivity type formed within said second impurity diffusion layer so as to contact neither said semi-conductor substrate nor said first impurity diffusion layer;
a source electrode connected to said third impurity diffusion layer;
a gate electrode formed between said first impurity diffusion layer and said third impurity diffusion layer and formed on said second impurity diffusion layer so as to imterpose an insulation film therebetween; and
a drain electrode connected to said first impurity diffusion layer.

Particularly, the present invention relates to a semiconductor device having a high breakdown voltage, f.e. a MOS transistor.

Such a semiconductor device is known from EP-A-0 248 292.

From EP-A-0 080 740 it is known to bias a channel region of a MOSFET to the same potential as the source.

In the US-A-3 787 962 it is disclosed to provide a circular source wiring of an insulated gate field transistor, said circular source having a gap through which a gate wiring crosses.

In Patent Abstracts of Japan, vol. 7, no. 214 and corresponding JP-A-58 106 871, there is disclosed a gate of a MOSFET having a step form.

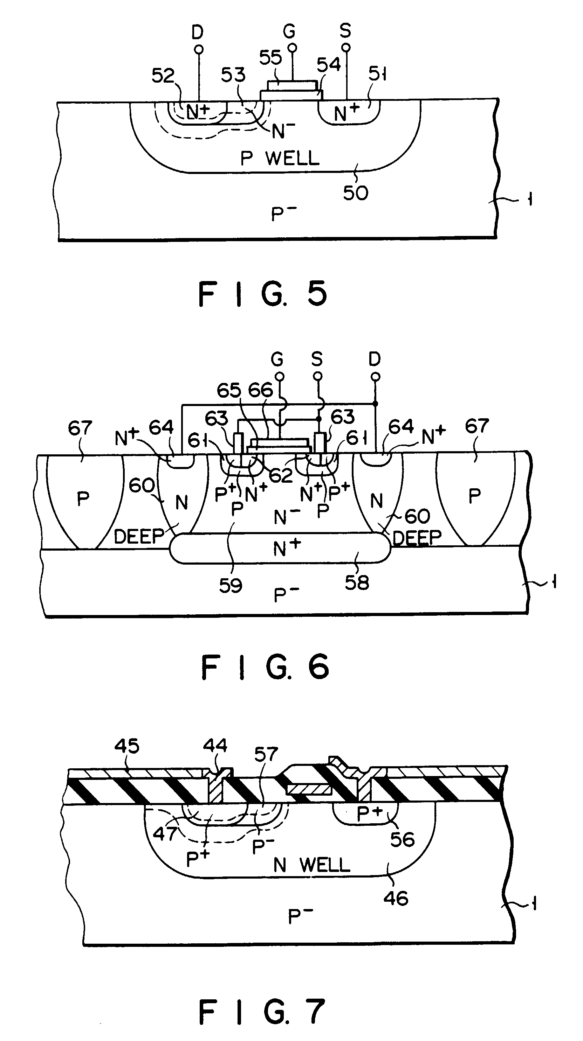

An example of the structure of a cross section of a conventional N-channel MOS transistor having a high breakdown voltage will be described with reference to Fig. 5.

P-type well 50 is formed on the surface of P-type semiconductor substrate 1. N-type source region 51 and N-type drain region 52, each having a concentration which is higher than that of well 50, are spaced apart from each other in the respective portions near the surface of well 50. N-type impurity diffusion layer 53, whose concentration is higher than that of well 50 and lower than that of drain region 52, is formed in a portion near the surface of well 50 in contact with the wall of drain region 52, which is near source region 51, and to substantially the same depth as that of drain region 52. Gate electrode 55 is formed directly on a channel region between diffusion layer 53 and source region 51 in well 50 through insulation layer 54. In a P-channel MOS transistor, as illustrated in Fig. 7, it is necessary only to set well 46, drain region 47, source region 56 and impurity diffusion layer 57 in a conductive state opposite to that of the N-channel MOS transistor.

A vertical MOS transistor is used as a transistor requiring a breakdown voltage which is higher than that of the above-mentioned MOS transistor. An example of the structure of a cross section of the vertical MOS transistor is shown in Fig. 6. In Fig. 6, N-type buried layer 58 of high impurity concentration is formed in the surface of P-type semiconductor substrate 1 of low impurity concentration. N-type epitaxial layer 59 whose impurity concentration is lower than that of buried layer 58 is formed on the surfaces of substrate 1 and buried layer 58. Deep N-layer 60 having a concentration which is higher than that of epitaxial layer 59 and lower than that of buried layer 58, is formed from the end portion of buried layer 58 to the surface of epitaxial layer 59. P-type back gate layer 61 serving as a channel region is formed in a portion near the surface of epitaxial layer 59 surrounded by deep N-layers 60 and along deep N-layer 60. N-type source region 62 and P-type diffusion layer 63 each having a concentration which is higher than that of back gate layer 61, are formed in P-type back gate layer 61. Drain region 64, whose concentration is higher than that of deep N-layer 60, is formed in the surface portion of deep N-layer 60. Gate electrode 66 is formed directly on back gate layer 61 so as to interpose insulation layer 65 therebetween. Isolation layers 67 for isolating elements are formed in the surroundings of deep N-layer 60 from the surface of epitaxial layer 59 to the surface of semiconductor substrate 1.

In the conventional N-channel MOS transistor shown in Fig. 5, a depletion layer, which is formed at a drain PN junction when a reverse bias (drain voltage: +[V], gate voltage: 0[V], source voltage: 0[V]) is applied between the drain and source regions, has a shape shown by broken lines. The expansion of the depletion layer towards the channel region is more suppressed in a region between drain region 52 and well 50 where diffusion layer 53 of low concentration is formed than in a region where drain region directly contacts well 50. However, since the impurity concentration of diffusion layer 53 is higher than that of well 50, the depletion layer expands to the channel region and a high voltage is easily applied to insulation layer 54 directly under gate electrode 55. For this reason, the insulation breakdown voltage of insulation layer 54 is equal to the breakdown voltage of the MOS transistor and it is thus difficult to use the MOS transistor with a voltage which is higher than the breakdown voltage of insulation layer 54. If insulation layer 54 is thickened, its breakdown voltage can be increased, but a parasitic capacity becomes large and an operation speed becomes high. Taking this problem into consideration, a breakdown voltage of at most 40 V can be obtained in this MOS transistor.

If a reverse bias is applied to the vertical MOS transistor shown in Fig. 6 whose breakdown voltage is much higher than that of the above-mentioned MOS transistor, the depletion layer at the drain P-N junction does not expand so widely toward the channel region and a high breakdown voltage can thus be obtained since the impurity concentration of epitaxial layer 59 in the drain region is lower than that of back gate layer 61. However, this vertical MOS transistor requires the formation of Deep N-layer 60 serving as a drain region, thereby increasing an element in area. Furthermore, since epitaxial layer 59 is used in the drain region, it needs to be isolated from other elements. After isolation layer 67 is formed, an element must be formed therein. Since isolation layer 67 needs to deeply expand from epitaxial layer 59 to semi-conductor substrate 1, the width of isolation layer 67 on the surface of epitaxial layer 59 is considerably large. When the thickness of epitaxial layer 59 is set to about 6 µm which is substantially the same as that of a well layer of the present invention mentioned later, the width of isolation layer 67 is about 12 µm which is twice as large as that of epitaxial layer 59. The width and depth of the isolation layer are very difficult to control and cannot be made constant. For this reason, the isolation layer is ususally formed so as to have a space in an element-forming region and thus the element area is further enlarged, which prevents an improvement in the packed density.

It is an object of the present application to provide a semiconductor device of the initially defined type which has an improved breakdown behaviour and improved high density packing.

This object is solved by a semiconductor device of the initially defined type which is characterized in that:
said source electrode is further connected to said second impurity diffusion layer ;
said second impurity diffusion layer surrounds as seen from above said first impurity diffusion layer;
a wiring layer is extracted from said drain electrode (9) outside said semiconductor substrate; and
said third impurity diffusion layer is ring-shaped and surrounds as seen from above said first impurity diffusion layer and has a gap through which said wiring layer crosses.

Preferred embodiments are listed in the dependent claims.

According to the present invention, since the third impurity diffusion layer and the wiring layer do not intersect, no parasitic FET structure will be formed in parallel to the main FET structure. Therefore, no adverse effects on the breakdown voltage of the main FET structure will occur.

Furthermore, if the conductivity type of an element next to the inventive semiconductor device is opposite, no isolation layer needs to be formed therebetween.

In the semiconductor device according to the present invention, since the second impurity diffusion layer (6) of the second conductivity type has an impurity concentration which is higher than that of the well (2), it is not influenced by the drain electrode and thus its shape is not changed by an applied high voltage. Therefore, the semiconductor device having a high breakdown voltage can be achieved.

Since the second impurity diffusion layer (6) is so constructed as to surround the first impurity diffusion layer (5), an area of the second impurity diffusion (6) can sufficiently be ensured and an element area can be reduced.

According to another aspect of the present invention, since the impurity concentration of a second island region (13) is lower than that of an impurity diffusion layer (16), a depletion layer does not so widely toward the impurity diffusion layer (16) when a reverse bias is applied. An electric field does not easily concentrate on the second impurity diffusion layer (6).

Since the second island region (13) is used as an active region for elements, the element construction is simplified. It is thus unnecessary to form an isolation layer for isolating the elements, so that the entire device can be greatly miniaturized.

This invention can be more fully understood from the following detailed description when taken in conjunction with the accompanying drawings, in which:
Fig. 1A is a cross-sectional view showing a semi-conductor device according to an embodiment of the present invention;
Fig. 1B is a cross-sectional view showing a semiconductor device according to another embodiment of the present invention;
Fig. 1C is a plan view showing a semiconductor device according to an embodiment of the present invention;
Fig. 2 is a cross-sectional view showing a semiconductor device according to still another embodiment of the present invention;
Figs. 3A to 3L are views showing steps of manufacturing the semiconductor device;
Fig. 4A is a cross sectional view showing a P-channel MOS transistor of high breakdown voltage;
Fig. 4B is a plan view showing the P-channel MOS transistor;
Fig. 5 is a cross-sectional view showing a conventional N-channel MOS transistor;
Fig. 6 is a cross-sectional view showing a conventional N-channel MOS transistor of a high breakdown voltage; and
Fig. 7 is a cross-sectional view showing a conventional P-channel MOS transistor.

Embodiments of the semiconductor device according to the present invention will be described with reference to the accompanying drawings.

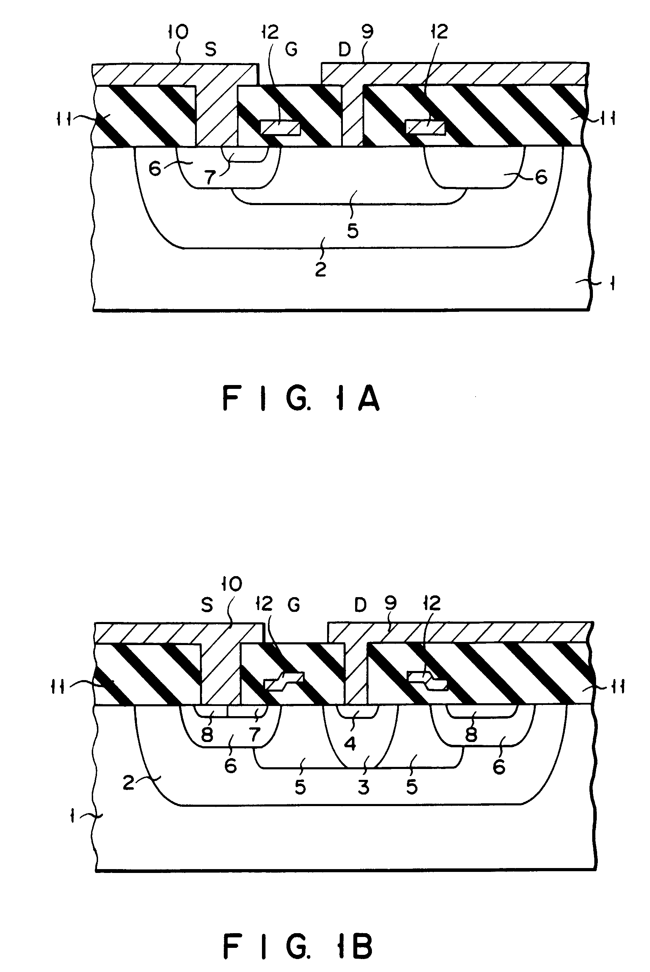

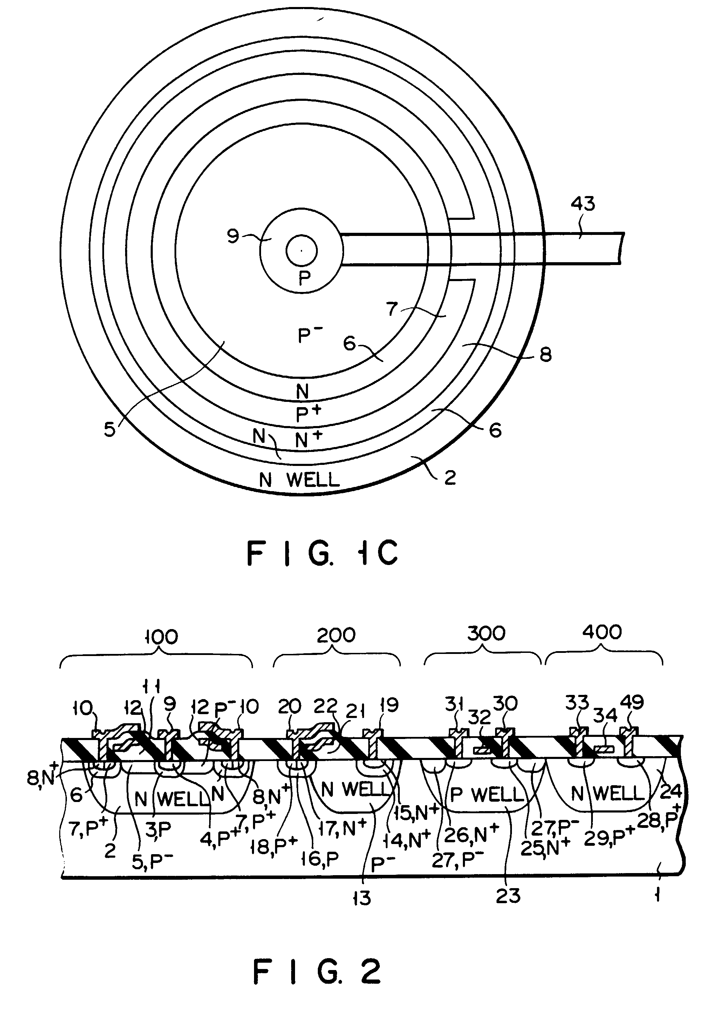

Fig. 1A is a cross-sectional view showing a semiconductor device according to an embodiment of the present invention; Fig. 1B is a cross-sectional view showing a semiconductor device according to another embodiment of the present invention; Fig. 1C is a plan view showing a semiconductor device according to an embodiment of the present invention.

In the embodiment shown in Fig. 1A, N-type island region 2 is formed on silicon semiconductor substrate 1 of a P-type conductivity, and first impurity diffusion layer 5 of a P type is formed on island region 2. Second impurity diffusion layer 6 of an N type having an impurity concentration which is higher than that of island region 2, is formed so as to surround first impurity diffusion layer 5. Third impurity diffusion layer 7 of a P-type conductivity is formed on second impurity diffusion layer 6 so as not to contact first impurity diffusion layer 5. Drain electrode (first electrode) 9 is formed on first impurity diffusion layer 5, and source electrode (second electrode) 10 is formed on second impurity diffusion layer 6 and third impurity diffusion layer 7. Gate electrode (third electrode) 12 is formed on first impurity diffusion layer 5 and second impurity diffusion layer 6 through first insulation layer 11.

An explanation will be given of P-channel MOS transistor 100 of high breakdown voltage according to the embodiment shown in Fig. 1B and on the left side of Fig. 2. In this transistor, N-type first island region 2 whose impurity concentration is higher than that of P-type silicon substrate 1 is formed. P-type fifth impurity diffusion layer 3, which has a higher impurity concentration than that of first island region 2 and serves as a drain, is formed in the upper middle portion of first island region 2. P-type fourth impurity diffusion layer 4 whose impurity concentration is higher than that of fifth impurity diffusion layer 3 is formed in diffusion layer 3. P-type first impurity diffusion layer 5, which has a lower impurity concentration than that of first island region 2 and is shallower than first island region 2, is formed in contact with the side wall of first island region 2. Second impurity diffusion layer 6, which has a higher impurity concentration than that of first impurity diffusion layer 5, is deeper than layer 5 and serves as a back gate, contacts and surrounds first impurity diffusion layer 5. P-type third impurity diffusion layer 7 which has a higher impurity concentration than that of second impurity diffusion layer 6 and serves as a source, and N-type sixth impurity diffusion layer 8 for ohmic-contacting island region 2, second impurity diffusion layer 6 and source electrode 10 are formed in contiguity with each other in a portion near the surface of second impurity diffusion layer 6. Drain electrode (first electrode) is formed on P-type fourth impurity diffusion layer 4 formed in second impurity diffusion layer 3, and source electrode (second electrode) 10 is formed on third impurity diffusion layer 7 and N-type impurity diffusion layer 8. Gate electrode (third electrode) 12 is formed stepwise on first and second impurity diffusion layers 5 and 6 through first insulation layer 11. The thickness of gate electrode 12 over second impurity diffusion layer 6 is smaller than that of gate electrode 12 over first impurity diffusion layer 5.

An explanation will be given of N-channel MOS transistor 200 of high breakdown voltage which is formed in contiguity with P-channel MOS transistor 100 mentioned above. N-type second island region 13 whose impurity concentration is comparatively higher than that of P-type substrate 1 is formed on substrate 1. N-type diffusion layer 14 which has a much higher impurity concentration than that of second island region 13 and serves as a drain is formed in a portion near the surface of region 13. N-type diffusion layer 15 whose impurity concentration is much higher than that of diffusion layer 14 is formed in layer 14. P-type impurity diffusion layer 16, which has a higher impurity concentration than that of second island region 13 and serves as back gate of N-channel MOS transistor 200, is formed so as to cut into part of the side wall of second island region 13, which faces P-channel MOS transistor 100. N-type impurity diffusion layer 17, which has a higher impurity concentration than that of impurity diffusion layer 16 and serves as a source electrode of N-channel MOS transistor 200, and P-type impurity diffusion layer 18 for ohmic-contacting substrate 1 and P-type impurity diffusion layer 16, are formed in contiguity with each other in a portion near the surface of impurity diffusion layer 16. Drain electrode (fourth electrode) 19 is formed on N-type impurity diffusion layer 15 whose impurity concentration is high, and source electrode (fifth electrode) 20 is formed on impurity diffusion layer 17 and P-type impurity diffusion layer 18. Gate electrode (sixth electrode) 22 is formed stepwise on impurity diffusion layer 16 and second island region 13 through third insulation layer 21. The thickness of gate electrode 22 over impurity diffusion layer 16 is smaller than that of gate electrode 22 over second island region 13.

An explanation will be given of N- and P-channel MOS transistors 300 and 400 of low breakdown voltage formed on the same substrate of the foregoing N-channel MOS transistor of high breakdown voltage. P-type fourth island region 23 and N-type third island region 24 are formed on the surface of P-type substrate 1. N-type drain diffusion layer 25 and source diffusion layer 26, whose impurity concentrations are each higher than that of fourth island region 23, are formed apart from each other in the upper portions of fourth island region 23. P-type impurity diffusion layers 27 whose impurity concentrations are each lower than that of fourth island region 23, are formed in contiguity with diffusion layers 25 and 26, respectively to prevent an erroneous operation due to a parasitic MOS transistor on the opposite surface of fourth island region 23 to the channel region. P-type drain diffusion layer 28 and source diffusion layer 29, whose impurity concentrations are each higher than that of third island region 24 are formed apart from each other in the upper portions of fourth island region 24. In N-channel MOS transistor 300, drain and source electrodes 30 and 31 are formed directly on drain and source diffusion layers 25 and 26, respectively, and gate electrode 32 is formed directly on the channel region through the insulation layer. In P-channel MOS transistor 400, drain and source electrodes 49 and 33 are formed directly on drain and source diffusion layers 28 and 29, respectively, and gate electrode 34 is formed directly on the channel region through the insulation layer.

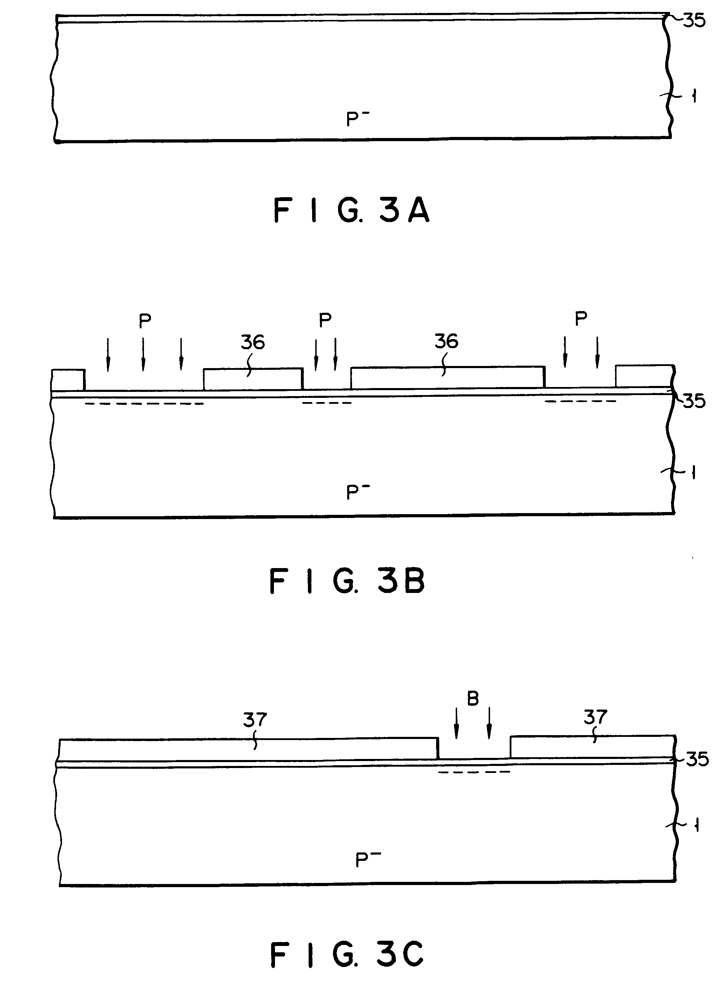

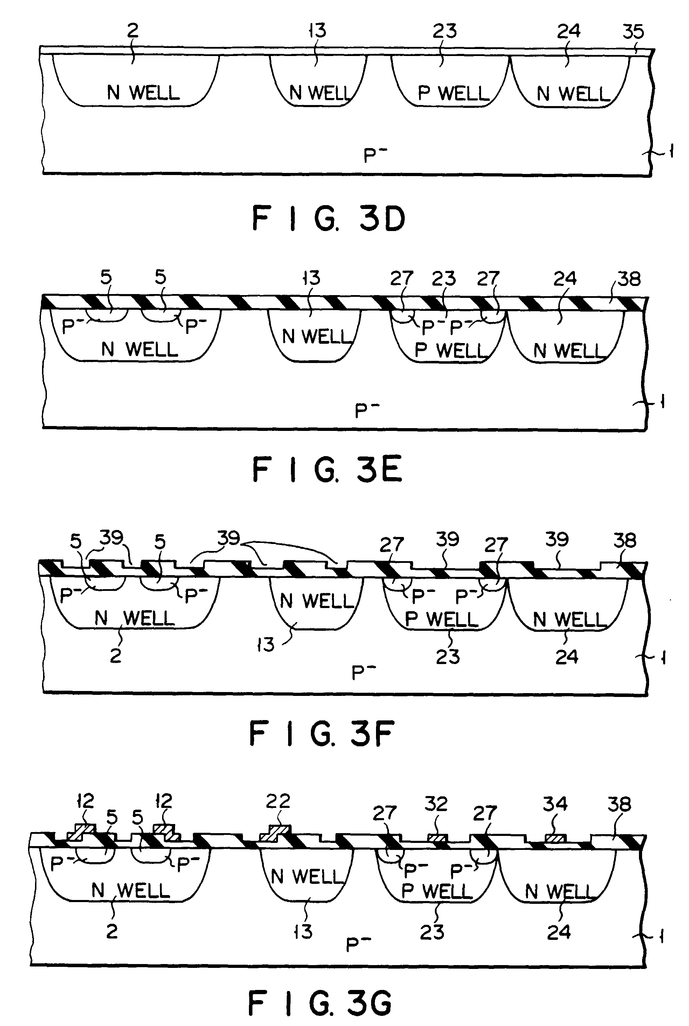

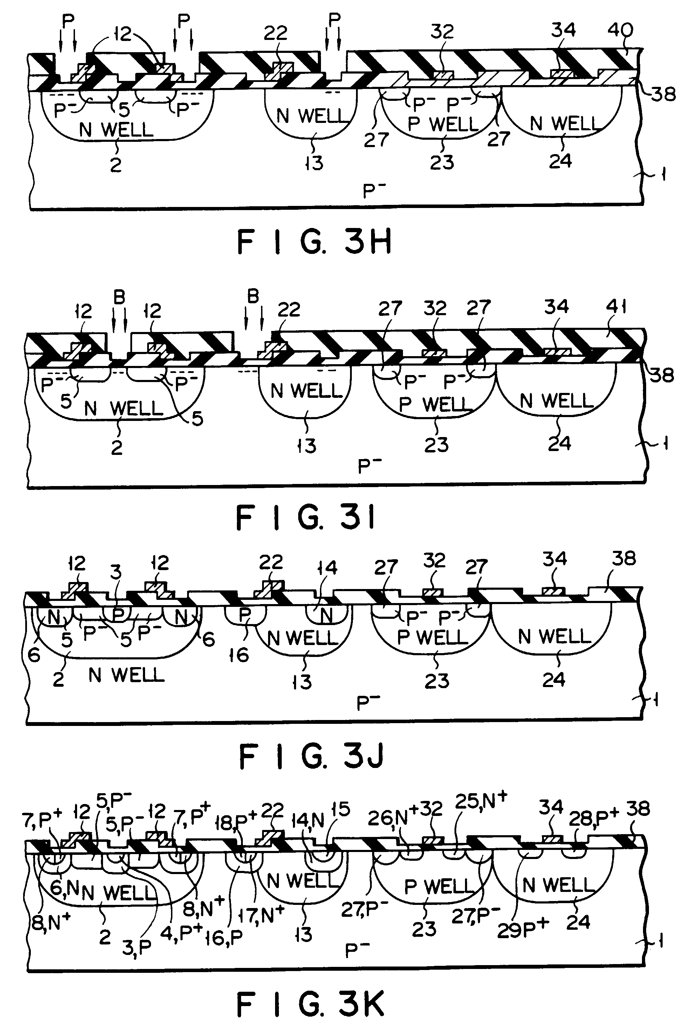

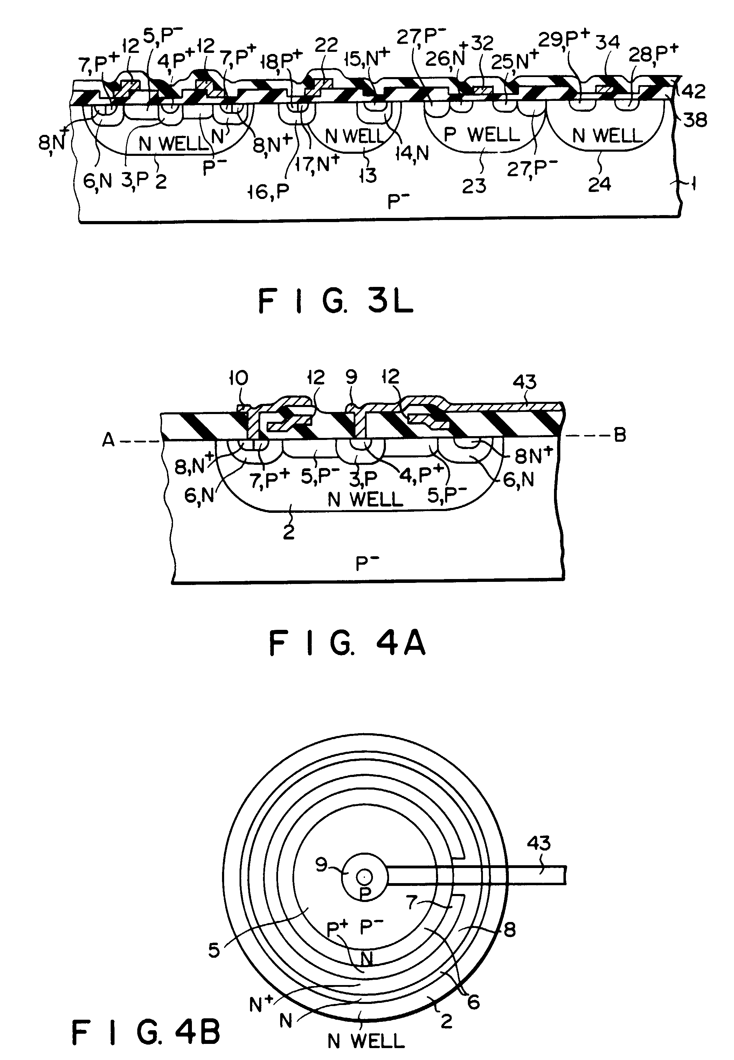

Figs. 3A to 3L show an example of a method for manufacturing a semiconductor device so constructed. P-type silicon substrate 1 whose impurity (boron) concentration is 1 × 10¹⁵ cm³ is thermally oxidized in the steam atmosphere of 1000°C to form oxide film 35 having a thickness of 1000 Å (100 nm) on the surface of substrate 1 (Fig. 3A). First photoresist pattern 36, which has openings where first, second and third island regions 2, 13 and 24 are to be formed, is formed on oxide film 35 by the photo-etching technique, and phosphorus is ion-implanted in the openings (Fig. 3B). First photoresist pattern 36 is removed, second photoresist pattern 37, which has an opening where fourth island region 23 is to be formed, is formed, and boron is ion-implanted in the opening (Fig. 3C). After second photoresist pattern 37 is removed, the remaining portion is treated for ten hours in the N₂ atmosphere of 1200°C to form first N-well (first island region) 2 whose impurity concentration is 1 × 10¹⁵ cm³, width is 100 µm and depth is 8 µm, second N-well (second island region) 13 whose impurity concentration is 1 × 10¹⁵ cm³, width is 60 µm and depth is 8 µm, N-type third island region 24, and P-type fourth island region 23 (Fig. 3D). A photoresist pattern, which has openings where first impurity diffusion layer 5 of P-channel MOS transistor 100 of high breakdown voltage and P-type diffusion layer 27 for a channel stopper of N-channel MOS transistor 300 of low breakdown voltage are to be formed, is formed, and boron having an impurity concentration of 1 × 10¹⁷ cm⁻³ is ion-implanted in the openings. The photoresist pattern is then removed and the surface of the remaining structure is oxidized again in the steam atmosphere of 1000°C to form oxide film 38 having a thickness of 1 µm (Fig. 3E). Only electrode forming region 39 in oxide film 38 is removed by the photo-etching technique. The remaining structure is thermally treated in the O₂ atmosphere of 1000°C to form first and third insulation layers 11 and 21 each having a thickness of 1000 Å (100 nm) and gate insulation films of P-channel and N-channel MOS transistors 400 and 300 of low breakdown voltage (Fig. 3F). Polycrystalsilicon having a thickness of 0.5 µm is deposited on the surface of the oxide film by the CVD technique, and a portion other than gate electrodes 12, 22, 32 and 34 is removed (Fig. 3G). Third photoresist pattern 40, which has openings where second impurity diffusion layer 6 of P-channel MOS transistor 100 of high breakdown voltage and N-type second impurity diffusion layer 6 of N-channel MOS transistor 200 of high breakdown voltage are formed, is formed, and phosphorus having an impurity concentration of 2 × 10¹⁷ cm⁻³ is ion-implanted in the openings (Fig. 3H). Similarly, fourth photoresist pattern 41, which has openings where fifth impurity diffusion layer 3 of P-channel MOS transistor 100 and impurity diffusion layer 16 of N-channel MOS transistor 200 are formed, is formed, and boron having an impurity concentration of 5 × 10¹⁷ cm⁻³ is ion-implanted in the openings (Fig. 3I). The structure is subjected to thermal treatment for an hour in the N₂ atmosphere of 1200°C to form second impurity diffusion layer 6, N-type diffusion layer 14, fifth impurity diffusion layer 3 and impurity diffusion layer 16 (Fig. 3J). A photoresist pattern is formed again, and only regions of the photoresist pattern for forming sixth impurity diffusion layer 8 for connecting source electrode 10 of P-channel MOS transistor 100 of high breakdown voltage and second impurity diffusion layer 6, impurity diffusion layer 17 serving as a source of N-channel MOS transistor 200 of high breakdown voltage, and drain and source diffusion layers 25 and 26 of N-channel MOS transistor 300 of low breakdown voltage, are removed, and arsenic having an impurity concentration of 1 × 10²⁰ cm³ is ion-implanted. The photoresist pattern is removed, and another photoresist pattern, which has openings where third impurity diffusion layer 7 of P-channel MOS transistor 100 of high breakdown voltage, P-type fourth impurity diffusion layer 4 of high impurity concentration, P-type diffusion layer 18 for ohmic-contacting source electrode 20 of N-channel MOS transistor 200 of high breakdown voltage and impurity diffusion layer 16, and drain and source diffusion layers 28 and 29 of P-channel MOS transistor 400 of low breakdown voltage are formed, is formed and boron having an impurity concentration of 1 × 10²⁰ cm³ is ion-implanted in the openings. After the photoresist pattern is removed, the remaining structure is annealed for thirty minutes in the N₂ atmosphere of 1000°C to form the above-mentioned layers (Fig. 3K). Further, SiO₂ layer 42 of 1 µm in thickness is deposited on the surface of the annealed structure by the CVD technique, and the structure is annealed again for ten minutes in the O₂ atmosphere of 1000°C (Fig. 3L). After that, contact holes are formed by the photo-etching technique in regions where first, second, fourth and fifth electrodes 9, 10, 19 and 20, and source and drain electrodes 33, 49, 31, 30 of N-channel and P-channel MOS transistors 400 and 300 of low breakdown voltage are to be formed, and an Aℓ film of 1 µm in thickness is deposited and patterned, thereby forming a semiconductor device having the structure shown in Fig. 2.

According to the embodiment shown in Fig. 2, in P-channel MOS transistor 100 of high breakdown voltage, fifth impurity diffusion layer 3 serving as a drain is formed in the middle of first island region 2. Layer 3 is surrounded by second impurity diffusion layer 6 serving as an N-type back gate whose impurity concentration is higher than that of P-type first impurity diffusion layer 5 serving as a back gate through first impurity diffusion layer 5. P-type third impurity diffusion layer 7 of high impurity concentration is formed in second impurity diffusion layer 6. Therefore, the depletion layer formed at the PN junction when a reverse bias is applied between the drain and source, expands toward first impurity diffusion layer 5 and does not expand so widely toward second impurity diffusion layer 6 since the impurity concentration of first impurity diffusion layer 5 is lower than that of second impurity diffusion layer 6. It is thus difficult that an electric field concentrate on first insulation layer 11 between second impurity diffusion layer 6 and gate electrode 12 and first insulation layer can be thinned. The current driving capacity per gate voltage of an element is improved and an area of the element can be reduced when a current of the same output. The parasitic capacity of the element is decreased, the current consumption can be decreased, and the operation speed can be increased. Since third impurity diffusion layer 7 surrounds fifth impurity diffusion layer 3, the channel region of third impurity diffusion layer 7 can have a sufficient width and the integration density can be improved even if the element is reduced. The depletion layer, which opposes the channel region and is formed when a reverse bias is applied to the conventional P-channel type MOS transistor shown in Fig. 7, may extend to P-type semiconductor substrate 1 through N-type well 46 and a short circuit may occur between drain layer 47 and substrate 1 since, if drain wiring layer 45 connected to drain electrode 44 crosses directly over the depletion layer, drain wiring layer 45 functions like a gate electrode. In the structure of the present invention however, fifth impurity diffusion layer 3 serving as a drain is surrounded by the channel region through first impurity diffusion layer 5, so that N-type first island region 2 contacts the drain (fifth impurity diffusion layer 3) only at the bottom of fifth impurity diffusion layer 3 and an influence due to the wiring can be neglected, thereby preventing the above-mentioned problem from being caused.

According to the structure of the present invention mentioned above, a MOS transistor of a low power consumption, a high-speed operation, a large current driving capacity and a high breakdown voltage, can be obtained. As shown in Figs. 4A and 4B, drain electrode extracting portion 43 of transistor 100 crosses and deletes source electrode 10 formed directly under drain electrode extracting portion 43 and P-type third impurity diffusion layer 7 serving as a source, and N-type sixth impurity diffusion layer 8 used for an ohmic contact is formed in these regions. Neither third impurity diffusion layer 7 serving as a source nor second impurity diffusion layer 6 serving as a back gate is influenced by drain electrode 9 and an element having stable characteristics can thus be achieved.

In N-channel MOS transistor 200 of high breakdown voltage according to the embodiment shown in Fig. 1C, N-type second island region 13 is used as part of the drain, and P-type impurity diffusion layer 16 for back gate, whose impurity concentration is higher than that of second island region 13 is formed so as to insert into part of island region 13. Even though a reverse bias is applied between the source and drain, the depletion layer does not extend toward impurity concentration 16 and second impurity diffusion layer 13. Therefore, since an electric field applied to third insulation layer 21 formed directly on impurity diffusion layer 17 is suppressed, it is possible to reduce the thickness of third insulation layer 21 formed directly on impurity diffusion layer 16 where a channel layer is to be formed, and to enlarge the current driving capacity per gate voltage and reduce the area of an element when a current having the same output flows, like the P-channel MOS transistor of high breakdown voltage. For this reason, the parasitic capacity of the element is decreased, the current consumption can be reduced and the operation speed can be increased. When the conventional MOS transistor is formed in contiguity with another element, an isolation layer for isolating the elements is required. In the MOS transistor of the present invention, second island region 13 and impurity diffusion layer 16, whose conductivity types differ from each other, are formed next to each other in the upper portion of P-type semiconductor substrate 1. If the conductivity type of an element next to MOS transistor 200 is opposite to that of MOS transistor 200, no isolation layer needs to be formed therebetween. The packed density of elements can thus be increased.

When the aforementioned P-channel MOS transistor 100 of high breakdown voltage, N-channel MOS transistor 300 of low breakdown voltage and P-channel MOS transistor 400 are formed on the same substrate as that of the MOS transistor according to the present invention, since N-type well (second island region) 13 is used as a drain, N-channel MOS transistor 200 of the present invention can be manufactured with the same mask as used when a well of P-channel MOS transistor 400 is formed, which simplifies the manufacturing process and is effective in forming a bipolar transistor on a single substrate. Conventionally, the source and drain of an N-channel MOS transistor were formed directly on the surface of a substrate. As shown in Fig. 1, however, the semiconductor device of the present invention is so constructed that N-channel MOS transistor 300 of low breakdown voltage is surrounded by P-type well (fourth island region) 23. Therefore, the concentration of the substrate can be freely set and thus optimized to increase the breakdown voltage of the element.

The foregoing embodiment is limited to a MOS transistor of one conductivity type. However, the same effects can be obtained in a MOS transistor of another conductivity type.

As described above, according to the present invention, the packed density is improved, and a low current consumption, a high speed operation and a high breakdown voltage can be achieved.

Reference signs in the claims are intended for better understanding and shall not limit the scope.

## Claims

1. A semiconductor device comprising:
a semiconductor substrate (1) of a first conductivity type;
a first well (2) of a second conductivity type formed on said semiconductor substrate of the first conductivity type;
a first impurity diffusion layer (5) of the first conductivity type formed on said well (2) without contacting said semiconductor substrate (1);
a second impurity diffusion layer (6) of the second conductivity type which has an impurity concentration which is higher than that of said well (2);
a third impurity diffusion layer (7) of the first conductivity type formed within said second impurity diffusion layer (6) so as to contact neither said semi-conductor substrate nor said first impurity diffusion layer (5);
a source electrode (10) connected to said third impurity diffusion layer (7);
a gate electrode (12) formed between said first impurity diffusion layer (5) and said third impurity diffusion layer (7) and formed on said second impurity diffusion layer (6) so as to interpose an insulation film (11) therebetween; and
a drain electrode (9) connected to said first impurity diffusion layer (5);
***characterized in that***
said source electrode (1) is further connected to said second impurity diffusion layer (6);
said second impurity diffusion layer (6) surrounds as seen from above said first impurity diffusion layer (5);
a wiring layer (43) is extracted from said drain electrode (9) outside said semiconductor substrate (1); and
said third impurity diffusion layer (7) is ring-shaped and surrounds as seen from above said first impurity diffusion layer and has a gap through which said wiring layer (43) crosses.

2. The semiconductor device according to claim 1, further comprising:
a fourth impurity diffusion layer (4) of said first conductivity type formed in said third impurity diffusion layer (5) and connected to said drain electrode (9), and having impurity concentration which is higher than that of said third impurity diffusion layer (5).

3. The semiconductor device according to claim 2, further comprising:
a fifth impurity diffusion layer (3) of said first conductivity type surrounding said fourth impurity diffusion layer (4) without contacting said second impurity diffusion layer (6) and having an impurity concentration which is higher than that of said first impurity diffusion layer (5) and lower than that of said fourth impurity diffusion layer (4), and contacting said well (2) at the bottom of said first impurity layer (5).

4. The semiconductor device according to one of claims 1 to 3, further comprising:
a sixth impurity diffusion layer (8) of said second conductivity type formed within said second impurity diffusion layer (6) and surrounding as seen from above said first and said third impurity diffusion layer (7) and having an impurity concentration which is higher than that of said second impurity diffusion layer (6), ond end of said sixth impurity diffusion layer (8) extending under one end of said gate electrode (12) under said wiring layer (43).

5. The semiconductor device according to one of claims 1 to 4, wherein
said insulation film (11) has a thicker portion under said gate electrode (12) toward the side of said first impurity diffusion region (5) than toward the side of said second impurity region (6), said gate electrode (12) being formed stepwise over said first (5) and second (6) impurity diffusion layers on said insulation film.

6. A semiconductor device comprising:
a MOSFET (100) having a channel of said first conductivity type according to one of claims 1 to 5; and
a MOSFET (200) having a channel of said second conductivity type formed next to said MOSFET (100) and a said semiconductor substrate (1).

7. The semiconductor device according to claim 6, characterized by further comprising a MOSFET (300) having a channel of said second conductivity type and of a low breakdown voltage formed on said semiconductor substrate (1).

8. The semicondutor device according to claim 6,
characterized by further comprising a MOSFET (400) having a channel of said first conductivity type and of a low breakdown voltage formed on said semiconductor substrate (1).

9. The semiconductor device according to one of the preceeding claims characterized in that said first conductivity type is a positive type.

10. The semiconductor device according to one of the preceeding claims, characterized in that said first conductivity type is a negative type.

## Patentansprüche

1. Halbleitereinrichtung, umfassend:
ein Halbleitersubstrat (1) eines ersten Leitfähigkeits-Typs;
eine erste Wanne (2) eines zweiten Leitfähigkeits-Typs, die auf dem Halbleitersubstrat des ersten Leitfähigkeits-Typs gebildet ist;
eine erste Verunreinigungsdiffusionsschicht (5) des ersten Leitfähigkeits-Typs, die auf der Wanne (2) ohne Kontaktieren des Halbleitersubstrats (1) gebildet ist;
eine zweite Verunreinigungsdiffusionsschicht (6) des zweiten Leitfähigkeits-Typs, die eine Verunreinigungskonzentration aufweist, die höher als die der Wanne (2) ist;
eine dritte Verunreinigungsdiffusionsschicht (7) des ersten Leitfähigkeits-Typs, die innerhalb der zweiten Verunreinigungsdiffusionsschicht (6) so gebildet ist, daß sie weder das Halbleitersubstrat noch die erste Verunreinigungsdiffusionsschicht (5) kontaktiert;
eine Source-Elektrode, die mit der dritten Verunreinigungsdiffusionsschicht (7) verbunden ist;
eine Gate-Elektrode (12), die zwischen der ersten Verunreinigungsdiffusionsschicht (5) und der dritten Verunreinigungsdiffusionsschicht (7) gebildet ist und auf der zweiten Verunreinigungsdiffusionsschicht (6) gebildet ist, so daß ein Isolationsfilm (11) dazwischen liegt; und
eine Drain-Elektrode (9), die mit der ersten Verunreinigungsdiffusionsschicht (5) verbunden ist;
dadurch gekennzeichnet, daß
die Source-Elektrode (1) ferner mit der zweiten Verunreinigungsdiffusionsschicht (6) verbunden ist;
die zweite Verunreinigungsdiffusionsschicht (6) von oben gesehen die erste Verunreinigungsdiffusionsschicht (5) umgibt;
eine Verdrahtungsschicht (43) von der Drain-Elektrode (9) von dem Halbleitersubstrat (1) nach außen extrahiert ist; und
die dritte Verunreinigungsdiffusionsschicht (7) ringförmig ist und von oben gesehen die erste Verunreinigungsdiffusionsschicht umgibt und einen Spalt aufweist, durch den die Verdrahtungsschicht (43) kreuzt.

2. Halbleitereinrichtung nach Anspruch 1, ferner umfassend:
eine vierte Verunreinigungsdiffusionsschicht (4) des ersten Leitfähigkeits-Typs, die in der dritten Verunreinigungsdiffusionsschicht (5) gebildet und mit der Drain-Elektrode (9) verbunden ist, und mit einer Verunreinigungskonzentration, die höher als diejenige der dritten Verunreinigungsdiffusionsschicht (5) ist.

3. Halbleitereinrichtung nach Anspruch 2, ferner umfassend:
eine fünfte Verunreinigungsdiffusionsschicht (3) des ersten Leitfähigkeits-Typs, die die vierte Verunreinigungsdiffusionsschicht (4) ohne Kontaktieren der zweiten Verunreinigungsdiffusionsschicht (6) umgibt und eine Verunreinigungskonzentration aufweist, die höher als diejenige der ersten Verunreinigungsdiffusionsschicht (5) und niedriger als diejenige der vierten Verunreinigungsdiffusionsschicht (4) ist und die Wanne (2) an dem Boden der ersten Verunreinigungsdiffusionsschicht (5) kontaktiert.

4. Halbleitereinrichtung nach einem der Ansprüche 1 bis 3, ferner umfassend:
eine sechste Verunreinigungsdiffusionsschicht (8) des zweiten Leitfähigkeits-Typs, die innerhalb der zweiten Verunreinigungsdiffusionsschicht (6) gebildet ist und von oben gesehen die erste und dritte Verunreinigungsdiffusionsschicht (7) umgibt und eine Verunreinigungskonzentration aufweist, die höher als diejenige der zweiten Verunreinigungsdiffusionsschicht (6) ist, wobei sich ein Ende der sechsten Verunreinigungsdiffusionsschicht (8) unter ein Ende der Gate-Elektrode (12) unter der Verdrahtungsschicht (43) erstreckt.

5. Halbleitereinrichtung nach einem der Ansprüche 1 bis 4, dadurch gekennzeichnet, daß
der Isolationsfilm (11) einen dickeren Abschnitt unter der Gate-Elektrode (12) in Richtung auf die Seite des ersten Verunreinigungsdiffusionsbereichs (5) hin als in Richtung auf die Seite des zweiten Verunreinigungsdiffusionsbereichs (6) hin aufweist, wobei die Gate-Elektrode (12) stufenweise über der ersten (5) und zweiten (6) Verunreinigungsdiffusionsschicht auf dem Isolationsfilm gebildet ist.

6. Halbleitereinrichtung, umfassend:
einen MOSFET (100) mit einem Kanal des ersten Leitfähigkeits-Typs gemäß einem der Ansprüche 1 bis 5; und
einen MOSFET (200) mit einem Kanal des zweiten Leitfähigkeits-Typs, der benachbart zu dem MOSFET (100) und einem Halbleitersubstrat (1) gebildet ist.

7. Halbleitereinrichtung nach Anspruch 6, dadurch gekennzeichnet, daß sie ferner einen MOSFET (300) mit einem Kanal des zweiten Leitfähigkeits-Typs und einer niedrigen Durchbruchspannung umfaßt, der auf dem Halbleitersubstrat (1) gebildet ist.

8. Halbleitereinrichtung nach Anspruch 6, ferner dadurch gekennzeichnet, daß sie einen MOSFET (400) mit einem Kanal des ersten Leitfähigkeits-Typs und einer niedrigen Durchbruchspannung umfaßt, der auf dem Halbleitersubstrat (1) gebildet ist.

9. Halbleitereinrichtung nach einem der vorangehenden Ansprüche, dadurch gekennzeichnet, daß der erste Leitfähigkeits-Typ ein positiver Typ ist.

10. Halbleitereinrichtung nach einem der vorangehenden Ansprüche, dadurch gekennzeichnet, daß der erste Leitfähigkeits-Typ ein negativer Typ ist.

## Revendications

1. Dispositif à semiconducteur comprenant :
un substrat semiconducteur (1) d'un premier type de conductivité ;
un premier puits (2) d'un second type de conductivité formé sur ledit substrat semiconducteur du premier type de conductivité ;
une première couche de diffusion d'impuretés (5) du premier type de conductivité formée sur ledit puits (2) sans entrer en contact avec ledit substrat semiconducteur (1) ;
une seconde couche de diffusion d'impuretés (6) du second type de conductivité qui présente une concentration en impuretés qui est supérieure à celle dudit puits (2) ;
une troisième couche de diffusion d'impuretés (7) du premier type de conductivité formée dans ladite seconde couche de diffusion d'impuretés (6) de manière à n'entrer en contact ni avec ledit substrat semiconducteur ni avec la première couche de diffusion d'impuretés (5) ;
une électrode de source (10) connectée à ladite troisième couche de diffusion d'impuretés (7) ;
une électrode de grille (12) formée entre ladite première couche de diffusion d'impuretés (5) et ladite troisième couche de diffusion d'impuretés (7) et formée sur ladite seconde couche de diffusion d'impuretés (6) de manière à interposer un film d'isolation (11) entre ; et
une électrode de drain (9) connectée à ladite première couche de diffusion d'impuretés (5),
caractérisé en ce que :
ladite électrode de source (1) est en outre connectée à ladite seconde couche de diffusion d'impuretés (6) ;
ladite seconde couche de diffusion d'impuretés (6) entoure, tel que vu depuis le dessus, ladite première couche de diffusion d'impuretés (5) ;
une couche de câblage (43) s'étend depuis ladite électrode de drain (9) jusqu'à l'extérieur dudit substrat semiconducteur (1) ; et
ladite troisième couche de diffusion d'impuretés (7) est en forme d'anneau et elle entoure, tel que vu depuis le dessus, ladite première couche de diffusion d'impuretés et elle présente un espace au travers duquel ladite couche de câblage (43) passe.

2. Dispositif à semiconducteur selon la revendication 1, comprenant en outre :
une quatrième couche de diffusion d'impuretés (4) dudit premier type de conductivité formée dans ladite troisième couche de diffusion d'impuretés (5) et connectée à ladite électrode de drain (9) et présentant une concentration en impuretés qui est supérieure à celle de ladite troisième couche de diffusion d'impuretés (5).

3. Dispositif à semiconducteur selon la revendication 2, comprenant en outre :
une cinquième couche de diffusion d'impuretés (3) dudit premier type de conductivité entourant ladite quatrième couche de diffusion d'impuretés (4) sans entrer en contact avec ladite seconde couche de diffusion d'impuretés (6) et présentant une concentration en impuretés qui est supérieure à celle de ladite première couche de diffusion d'impuretés (5) et qui est inférieure à celle de ladite quatrième couche de diffusion d'impuretés (4), et entrant en contact avec ledit puits (2) au niveau de la partie inférieure de ladite première couche d'impuretés (5).

4. Dispositif à semiconducteur selon l'une quelconque des revendications 1 à 3, comprenant en outre :
une sixième couche de diffusion d'impuretés (8) dudit second type de conductivité formée dans ladite seconde couche de diffusion d'impuretés (6) et entourant, tel que vu depuis le dessus, lesdites première et troisième couches de diffusion d'impuretés (7) et présentant une concentration en impuretés qui est supérieure à celle de ladite seconde couche de diffusion d'impuretés (6), une extrémité de ladite sixième couche de diffusion d'impuretés (8) s'étendant sous une une extrémité de ladite électrode de grille (12) sous ladite couche de câblage (43).

5. Dispositif à semiconducteur selon l'une quelconque des revendications 1 à 4, dans lequel ledit film d'isolation (11) comporte une partie plus épaisse sous ladite électrode de grille (12) en direction du côté de ladite première région de diffusion d'impuretés (5) qu'en direction du côté de ladite seconde région d'impuretés (6), ladite électrode de grille (12) étant formée en marche sur lesdites première (5) et seconde (6) couches de diffusion d'impuretés sur ledit film d'isolation.

6. Dispositif à semiconducteur comprenant :
un MOSFET (100) comportant un canal dudit premier type de conductivité selon l'une quelconque des revendications 1 à 5 ; et
un MOSFET (200) comportant un canal dudit second type de conductivité formé à la suite dudit MOSFET (100) et un dit substrat semiconducteur (1).

7. Dispositif à semiconducteur selon la revendication 6, caractérisé en ce qu'il comprend en outre un MOSFET (300) comportant un canal dudit second type de conductivité et présentant une tension de claquage faible formé sur ledit substrat semiconducteur (1).

8. Dispositif à semiconducteur selon la revendication 6, caractérisé en ce qu'il comprend en outre un MOSFET (400) comportant un canal dudit premier type de conductivité et présentant une tension de claquage faible formé sur ledit substrat semiconducteur (1).

9. Dispositif à semiconducteur selon l'une quelconque des revendications précédentes, caractérisé en ce que ledit premier type de conductivité est un type positif.

10. Dispositif à semiconducteur selon l'une quelconque des revendications précédentes, caractérisé en ce que ledit premier type de conductivité est un type négatif.
